Europäisches Patentamt

European Patent Office

Office européen des brevets

(11) Publication number: **0 164 128 B1**

# EUROPEAN PATENT SPECIFICATION

(45) Date of publication of patent specification: **27.12.90**

(51) Int. Cl.⁵: **G 03 F 7/20,** B 41 C 1/10

(21) Application number: **85107039.1**

(22) Date of filing: **07.06.85**

(54) Process for making lithographic printing plates, and printing plates made by the process.

(30) Priority: **08.06.84 US 618586**

(43) Date of publication of application:
**11.12.85 Bulletin 85/50**

(45) Publication of the grant of the patent:
**27.12.90 Bulletin 90/52**

(84) Designated Contracting States:
**BE DE FR GB IT NL**

(56) References cited:
**DE-A-2 725 308
DE-A-2 728 858
FR-A-2 258 650
FR-A-2 396 336
GB-A-1 603 920
US-A-3 664 737
US-A-3 964 389
US-A-4 063 949
US-A-4 248 959**

(73) Proprietor: **Fromson, Howard A.
15 Rogues Ridge Road
Weston Connecticut 06880 (US)**

(72) Inventor: **Fromson, Howard A.
15 Rogues Ridge Road
Weston Connecticut 06880 (US)**
Inventor: **Gracia, Robert F.
P.O. Box 104 Old Turnpike Road
Woodstock Connecticut 06282 (US)**

(74) Representative: **Zapfe, Hans, Dipl.-Ing.
Am Eichwald 7, Postfach 20 01 51
D-6056 Heusenstamm 2 (Rembrücken) (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates to a lithographic printing plate being imageable with an yttrium-aluminium-garnet (YAG) laser producing incident laser radiation of a wave length at 1,06 µm.

In the art of lithographic printing plates, there are many options for producing an image useful for printing. These include an additive, one-step resin reinforced image; a subtractive photo-polymer image; a subtractive diazo-resin reinforced image; a subtractive photo-polymer on diazo image; an additive one-step reinforced image post-cured with heat, a subtractive diazo image; photo-polymer image reinforced and post-exposed, bi-metal and tri-metal plates and resin particles in a diazo matrix. The image is conventionally formed by exposing a plate coated with a light sensitive material to UV light through a full size film negative or positive.

The lithographic printing industry has been searching for a dependable laser imagable lithographic printing plate for more than ten years. In the newspaper industry the laser imagable plate would enable the newspaper to assemble its copy in a metropolitan center and to have it printed in a plant far removed from the center. In some instances, this would be done in a satellite printing plant situated only a few miles from the editorial offices, and in other instances, the printing plants would be located many thousands of miles away. Additionally, other printing establishments, among them small newspapers, have been interested in a laser imagable plate which would permit them to eliminate their silver halide negatives.

There exist three modes of direct laser imagable plates today: electrostatic, ultraviolet, and infrared.

The electrostatic plates involve the electrostatic toning of a lithographic substrate either directly or by transfer from an intermediate.

The ultraviolet imagable plates are imaged by very powerful, generally Argon-Ion lasers which require large inputs of energy as well as water cooling. Typical units are manufactured by EOCOM, a division of American Hoechst and are powered in some cases by lasers delivering as much as 18 watts of output energy. Since the Argon-Ion generates only about 15% of its energy in the UV wave lengths, it requires a very powerful laser. Efficiency in the 4—5 watt total spectrum range has been claimed, but present information indicates that there is no commercial unit performing at this energy level.

US—A—4 063 949 discloses a method for making lithographic printing plates and the printing plates made by this process. An aluminium substrate has an anodic coating with a weight of at least 3 g/m² and a further coating of a diazo compound being sensitive to laser radiation. It is stated, that the aluminium substrate can be grained mechanically, chemically or electrolytically before the anodic oxidation. The tendency shown with respect to the thickness of the anodic coating is, that the coating weight of the anodic coating is substantially above 3 g/m², i.e. as far as 15 g/m² with an optimum range of between 5 and 12 g/m². The laser means suggested are argon lasers, krypton lasers, helium-cadmium lasers which emit between 300 and 600 nm, as well as $CO_2$ lasers emitting at about 10,6 µm or YAG lasers emitting at about 1,06 µm. There is no statement, that the topography of the anodic coating must be such, that a substantial portion of the laser radiation is being absorbed and transferred into radiation of a longer wave-length. There is furthermore no statement, that the thickness of the anodic coating shall be in a specific relationship to the wave-length of the laser radiation, and there is also no statement, that at least another portion of the laser radiation is transferred into radiation of a longer wave-length by particles of an energy absorbing material.

DE—A—2 725 308 discloses another process for the production of lithographic printing plates and the printing plates produced according to this process, starting from an aluminium substrate, which can be grained before the anodic oxidation. This document is silent with respect to the thickness of the anodic coating, and there is also no disclosure of a relationship between the wave-length of the laser radiation and the thickness of the anodic coating. The laser means suggested emit radiation with a wave-length, which is essentially in the UV-range. It is not disclosed, that the topography of the aluminium substrate shall trap and convert the incident laser radiation into a radiation of a longer wave-length and it is also not stated, that any particles of an energy absorbing material are present, in order to convert another portion of the laser radiation into a radiation of a longer wave-length.

FR—A—2 258 650 and US—A—3 964 389 disclose making a printing plate by laser transfer. On a polyester film as a substrate there is a coating with energy absorbing particles like carbon black. In order to record an information on this polyester film portions of the coating are blasted off due to combustion created by a laser beam. It is also disclosed, that the polyester film and the blasting effect can be used to transfer the blasted-off material to an aluminium plate in order to make the aluminium plate a printing plate. There is no disclosure, to have a very specific topography and also a very specific anodic coating on the aluminium plate. The substrate is a bare litographic plate, and the product is variable in quality and expensive. There is no disclosure to transfer the wave-length of laser radiation into longer wave-lengths.

Diazo resins are insolubilized by radiation such as UV light (320—400 nm wave length) or IR radiation beginning at about 4650 nm in the infrared. At energy sources of 1060 nm, diazo resins are unaffected. Since conventional YAG lasers function at 1060 nm they are unsuited for directly imaging diazo sensitized plates. It is an object of the present invention to overcome this drawback.

In its broadest aspects this invention provides a lithographic printing plate being imageable with an yttrium-aluminium-garnet (YAG) laser producing incident laser radiation of a wave length at 1,06 µm, comprising:

a) a grained aluminium substrate having an anodic coating and topography for trapping and converting a substantial portion of said laser radiation into a radiation of a longer wave length,

b) the anodic coating having a thickness between the said laser wave length of 1,06 μm and 1,30 μm thereby absorbing at least 50% of the said incident laser radiation,

c) a further coating of a diazo resin being sensitive to actinic radiation, and

d) particles of an energy absorbing material contained in at least one of the anodic coating and the diazo resin.

The topography of the grained and anodized sheet is having such a structure that it traps and converts a substantial portion of incident radiation, for example, laser radiation, which passes through the organic coating without substantially affecting same into radiation that will change the organic coating upon emerging from the light trap. Having a diazo resin as a photosensitive material, the converted radiation alters the solubility of the material and renders it ink loving.

It is believed that the incident radiation passes through the diazo resin without changing this coating and is simultaneously absorbed by the anodic oxide coating and reflected by the underlying aluminium metal. What results is re-emergent longer wave radiation now in a form which will not pass through the diazo resin without changing it. Energy absorbing material in particle form, such as carbon black also absorbs incident radiation and re-radiates it at a longer wave length which will change the diazo resin.

The present invention provides a grained and anodized, hydrophilic aluminium substrate having a grain configuration capable of internally trapping and reflecting laser radiation to increase its wave length and a diazo resin coating which becomes insoluble and ink loving upon exposure to actinic radiation such as UV light or heat but which is normally unaffected by and transparent to conventional laser radiation, e.g. 1060 nm which is the output of a YAG laser. The grained substrate and the particulate energy absorbing material convert the laser energy (which would otherwise pass through the coating) to longer wave actinic energy, such as infrared energy of 4650 nm or more, which causes the laser struck areas to become insoluble and ink loving.

A lacquer containing a cationic material can also be used to cover or patch holes in the laser struck image areas of the photosensitive coating if the laser ablates or removes portions of the image exposing the underlying substrate.

It is possible to image diazo with a YAG laser where the grain is relatively deep relative to its width so as to internally trap the output of the YAG laser. Such lithographic substrates are characterized by high light absorption and the laser radiation bounces back and forth laterally within the valley of the grain as it is absorbed and remitted at progressively longer wave lengths.

Diazo resins, although unaffected by light at wave lengths between 800 nm and 1060 nm have a very pronounced reaction to radiant energy in the infrared at 4650 nm or more. It is believed, that in the process of imaging, the YAG laser energy is degraded and its wave length becomes progressively longer as it is absorbed and re-radiated from the sidewalls of the grain. It is believed, that the diazo nitrogen-to-nitrogen bond is broken at the 4650 nm wave length. In other words, the effective wave length of the YAG laser is shifted from 1060 nm to 4650 nm and higher by creating an optical light trap mechanism using the sidewalls of the grain so the diazo resin sees the energy at its infrared sensitive peak of 4650 nm.

The present invention provides a YAG-laser imagable, lithographic printing plate comprising a grained and anodized, hydrophilic (anionic and negatively charged) aluminium substrate coated with a photosensitive material which has its solubility characteristics altered when struck by actinic radiation but which is transparent to laser radiation. The grain configuration of the substrate and the combination of the grain and carbon black is capable of trapping, absorbing and reradiating the laser radiation to convert it into actinic energy which will alter the solubility of the photosensitive material.

The substrate is grained and anodized aluminium which is preferably silicated to render it hydrophilic.

Where the level of laser radiation is relatively high, ablation or removal of diazo in the imaged areas can be experienced. If this occurs, a lacquer or the like containing a cationic material can be used to cover or patch the ablation areas.

Most hydrophilic, lithographic substrates are known to have a negative charge. Removal of imaged diazo via ablation with a laser can create undesirable voids or holes exposing the negatively charged substrate in the imaged areas. This leads to voids in the imaged areas. These image voids can be illuminated by using cationic lacquers as detailed herein.

A grained, anodized surface creates hills and valleys which are believed to absorb and re-radiate laser radiation at higher wave lengths to which the coatings are sensitive. US—A—4 183 788 sets forth a preferred process for graining aluminium for use as lithographic substrate in the invention.

One measure of a suitably grained and anodized substrate for use in the invention is absorption of energy at various wave lengths. The following table illustrates this:

EP 0 164 128 B1

## Table I

### Percent Absorption of Energy

| No. | Substrate | 350 nm | 600 nm | 825 nm | 1060 nm |
|---|---|---|---|---|---|
| 1. | S.D. Warren- grained and anodized | 3 | 14 | 27 | 12 |
| 2. | Omega-Ano- Coil grained and anodized | 33 | 45 | 52 | 39 |
| 3. | Advance Offset grained and anodized | 41 | 38 | 50 | 33 |
| 4. | No-grain- anodized | 16 | 32 | 50 | 39 |
| 5. | No grain- anodized | 2 | 20 | 48 | 23 |
| 6. | Grained and anodized | 59 | 65 | 75 | 63 |
| 7. | Delta-Ano- Coil grained and anodized | 60 | 63 | 73 | 65 |
| 8. | Grained and anodized | 61 | 67 | 75 | 64 |
| 9. | Grained and anodized | 86 | 80 | 76 | 79 |

Absorption measurements were taken with a Perkin Elmer Model 330 Spectrophotometer with an integrating sphere for measuring light from diffused surfaces.

A further measure of a suitably grained and anodized substrate is anodic coating weight and thickness. For example, the substrates set forth in Table I above have the following anodic coating weights and thicknesses:

## Table II

| Substrate No. | Coating Thickness μm | Coating Weight grams per m$^2$ |
|---|---|---|
| 1. | 0.7 | 1.40 − 1.55 |
| 2. | 0.5 | 1.40 − 1.71 |
| 7. | 0.85 | 1.86 − 1.94 |
| 8. | 1.30 | 2.79 |
| 9. | 1.30 | 3.10 |
| 10. (Alpha-Ano-Coil) | 0.43 | 0.9 − 1.24 |
| 11. (PSQ-Ano-Coil) | 1.10 | 2.48 − 2.79 |

Suitable substrates can be characterized as having an anodic coating thickness between the wave length of the incident radiation and 1,30 μm and an absorption of at least 40% and preferably more than 55 to 60% of the incident radiation. This is demonstrated by the fact that substrates 1—5 and 10 did not consistently result in an acceptable printing plate following the procedures of Example 1 herein whereas substrates 6, 8, 9 and 11 consistently produced acceptable lithographic printing plates following Example 1 herein. Substrates 6, 8, 9 and 11 are embodiments of the invention.

The substrate for use in the lithographic printing plate according to the invention is grained and anodized aluminium which can be silicated to render it hydrophilic (US—A—3 181 461, Fromson). A preferred material is brush grained, anodized and silicated aluminium (US—A—4 183 788).

The photosensitive material is a diazo resin having reactive sites which are capable of being chemically altered by actinic radiation to adhere to diazo resin to the hydrophilic substrates in the laser struck areas. Suitable diazo compounds are described, *inter alia*, in US-Patents 2 063 631, 2 677 415, 2 679 498, 3 050 502, 3 311 605, 3 163 633, 3 406 159 and 3 277 074.

A suitable diazo resin for the present invention is the condensation product of 3-methoxy-4-diazodiphenylamine and paraformaldehyde. Another suitable diazo resin is one commercially available from Fairmount Chemical Company designated Diazo Resin No. 4.

To produce an imaged lithographic printing plate, a plate produced by coating a hydrophilic grained substrate with a photosensitive material such as diazo resin is first exposed via a laser, preferably a LogEscan YAG laser plate maker which operates at 1060 nm.

The exposed plate is then developed. Where the diazo is insolubilized only in the image area, any suitable developer or lacquer-developer may be used. However, because the power output of a YAG laser can vary, it is possible that portions of the image will be removed during laser exposure to reveal portions of the hydrophilic substrate. By using a cationic lacquer developer such as Black Diamond by Western Litho or Graphic T by Samson these voids in the imaged areas are replaced by adherent resins. Alternatively, cationic surfactants such as aqueous quaternary ammonium salts can be applied first, followed by the application of a resin lacquer. The use of a cationic surfactant or lacquer-developer produces an image, portions of which are comprised of resin bonded to destroyed diazo and others comprised of resins bonded to negatively charged substrates via the positively charged cationic surfactants.

An aqueous, anionic developer can be used to develop a plate if laser exposure converts diazo only to its insoluble state without removing portions of the image. If image removal occurs, a cationic lacquer-developer is used first and an anionic finisher can be used to remove any residual diazo that remains in the background of the plate (cf. US—A—4 391 897 and US—A—4 414 315).

The following examples illustrated the invention and the manner in which it may be performed without limiting same in any manner:

### Example 1

A coil of aluminium (Alloy 1110 — Alcoa) was brush grained in web form using an aqueous abrasive slurry containing alumina (A2 — Alcoa) according to US—A—4 183 788. After graining, the web was treated in a heated bath at 38°C of dilute sodium hydroxide, rinsed, dipped in an aqueous solution of 50% nitric acid, rinsed, anodized for 32 ampere-minutes to achieve an anodic coat weight of 0,22—0,25

milligrams alumina/cm², rinsed, dipped in a bath of sodium silicate (3%), rinsed and dried. The grained, anodized, and silicated surface prepared in this manner is similar to substrate No. 11 in Table II above.

Single page newspaper size plates were cut from the coil described above. Each plate was coated with a light sensitive coating having

Water — 500 ccm
Diazo (Fairmount Chemical Co. Diazo Resin) 42.0 grams
Aquablak 115 (carbon black, Borden Chemical Co.) 84.50 grams.

The plates were coated on a Talboys coater — 1 pass. The coated plate was placed in a Datrax 760 YAG laser plate maker which is a YAG laser with an output of 8 or 9 watts of power, at 1060 nm (l.06 microns) and scanned for approximately 2 minutes at a scanning rate of 1000 lines per minute. The thus exposed plate was then placed in a Tasope automatic lacquering processor containing black non-ionic lacquer made by Fairmount Chemical Company. The imaged plate accepted laquer and ink readily. The plate from the processor has a strong black image. This plate was placed in a Goss metro press and 25,000 good copies were made with no apparent wear.

## Example 2

A newspaper size plate was brush grained, anodized, silicated, coated and exposed to a laser as in Example 1.

The exposed plate is immersed in a 5% solution of sodium lauryl sulfate, rinsed and dryed. This plate will accept ink readily without further lacquering.

## Example 3

A coil of aluminium (Alloy 1100) was brush grained, in web form, using an aqueous abrasive slurry containing alumina (T61, 325 mesh, Alcoa) according to US—A—4 183 788. After graining, the web was treated by immersion in dilute caustic at 27°C. Next, the web was rinsed, treated with nitric, rinsed, anodized at 38 ampere-minutes in sulfuric acid, rinsed, silicated (3%), rinsed, and dried. This brush, grained, anodized, silicated substrate is similar to substrates Nos. 9 and 11 in Table I above.

Newspaper size plates are cut from this coil and coated with the following coating composition:

1800 ccm Diazo (prepared in Example 1)
180 ml Aquablak G (Borden Chemical Co.)
4.5 gr Malachite Green
360 ml Isopropyl alcohol.

The plates were coated in a three roll coater face up (Union Tool Company) — 1 pass. After coating, three (3) plates were exposed on a Datrax 760 Laser plate maker. These plates were then lacquered to produce a strong, black, adherent image. The plates were placed on a Goss Metropress and printed more than 50,000 good copies with no wear.

## Example 4

A newspaper size plate was brush grained, anodized and silicated, coated and exposed as in Example 1. This plate was then lacquered with Western Litho's Black Diamond lacquer containing a cationic material. A very intense adherent, abrasive resistant, black image resulted from this treatment.

## Example 5

A newspaper size plate was brush grained, anodized, silicated, coated, and exposed as in Example 3. This plate was lacquered with Samson developer containing a cationic material made by Graphic Arts Technical and Consulting Services. As in Example 4, a very intense, adherent, abrasive resistant image appeared.

## Comparative Example

A newspaper size plate was brush grained as in Example 1. After graining, the plate was treated in caustic at a higher temperature (49°C) than in Example 1. The plate was then rinsed, immersed in dilute nitric, rinsed, anodized in sulfuric acid for 18 ampere-minutes, rinsed, silicated, rinsed, and dried. This substrate is similar to substrate No. 2 in Table 1 above. The plate was sensitized as in Example 3 and exposed in a Datrax 760 Laser plate maker. Four (4) plates were exposed at 6, 7, 8 and 9 watts. These plates were lacquered with Fairmount lacquer. Non-acceptable image quality results on all plates, 9 watts being better than 6 watts. When the same plates were lacquered with Western Black Diamond developer, better images at all power levels resulted, but they were still not functional as printing plates.

# EP 0 164 128 B1

## Claims

1. Lithographic printing plate being imageable with an yttrium-aluminium-garnet (YAG) laser producing incident laser radiation of a wave length at 1,06 μm, comprising:

a) a grained aluminium substrate having an anodic coating and a topography for trapping and converting a substantial portion of said laser radiation into a radiation of a longer wavelength,

b) the anodic coating having a thickness between the said laser wavelength of 1,06 μm and 1,30 μm thereby absorbing at least 50% of the said incident laser radiation,

c) a further coating of a diazo resin being sensitive to actinic radiation, and

d) particles of an energy absorbing material contained in at least one of the anodic coating and the diazo resin.

2. Lithographic printing plate of claim 1, wherein said grained and anodized aluminium substrate is anionic and negatively charged.

3. Lithographic printing plate of claim 1 developed with a developer containing a cationic material.

4. Lithographic printing plate of claim 1 wherein the substrate is silicated and hydrophilic.

5. Lithographic printing plate of claim 1 wherein the energy absorbing material is carbon black.

6. Lithographic printing plate of claim 1 wherein the energy absorbing material is graphite.

## Patentansprche

1. Lithografische Druckplatte, die mit einem Yttrium-Aluminium-Granat-(YAG)-Laser belichtbar ist, der eine auftreffende Laser-Strahlung mit einer Wellenlänge um 1,06 μm erzeugt, mit:

a) einem gekörnten Aluminiumsubstrat mit einer anodischen Schicht und einer Topografie für das Einfangen eines wesentlichen Anteils der Laserstrahlung und für deren Umwandlung in eine Strahlung größerer Wellenlänge,

b) wobei die anodische Schicht eine Dicke hat, die zwischen der besagten Wellenlänge des Lasers von 1,06 μm und 1,30 μm liegt und dadurch mindestens 50% der auftreffenden Laser-Strahlung absorbiert,

c) einer weiteren Schicht aus einem Diazo-Harz, das gegenüber aktinischer Strahlung sensibilisiert ist, und

d) Partikeln aus einem Energie absorbierenden Material, die in mindestens einer der anodischen Schicht und der Diazo-Harz-Schicht enthalten sind.

2. Lithografische Druckplatte nach Anspruch 1, bei der das gekörnte und anodisierte Aluminiumsubstrat anionisch und negativ geladen ist.

3. Lithografische Druckplatte nach Anspruch 1, die mit einem Entwickler entwickelt ist, der einen kationischen Stoff enthält.

4. Lithografische Druckplatte nach Anspruch 1, bei der das Substrat siliziert und hydrophil ist.

5. Lithografische Druckplatte nach Anspruch 1, bei der das Energie absorbierende Material Ruß ist.

6. Lithografische Druckplatte nach Anspruch 1, bei der das Energie absorbierende Material Grafit ist.

## Revendications

1. Planche d'impression lithographique sur laquelle on peut former une image avec un laser ou grenat d'yttrium-aluminium (YAG) produisant un rayonnement laser incident d'une longueur d'onde de 1,06 μm, comprenant:

a) un substrat d'aluminium grainé ayant un revêtement anodique et une topographie permettant de piéger et de transformer une partie notable de ce rayonnement laser en un rayonnement de longueur d'onde plus élevée,

b) le rayonnement anodique ayant une épaisseur comprise entre cette longueur d'onde du laser de 1,06 μm et 1,30 μm, absorbant ainsi au moins 50% de ce rayonnement laser incident,

c) un revêtement supplémentaire d'une résine diazoïque sensible au rayonnement actinique, et

d) des particules d'une matière absorbant l'énergie contenues dans le revêtement anodique et/ou dans la résine diazoïque.

2. Planche d'impression lithographique de la revendication 1, dans laquelle ce substrat d'aluminium grainé et anodisé est anionique et chargé négativement.

3. Planche d'impression lithographique de la revendication 1 développée avec un révélateur contenant une matière cationique.

4. Planche d'impression lithographique de la revendication 1, dans laquelle le substrat est silicaté et hydrophile.

5. Planche d'impression lithographigue de la revendication 1, dans laquelle la matière absorbant l'énergie est du noir de carbone.

6. Planche d'impression lithographique de la revendication 1, dans laquelle la matière absorbant l'énergie est du graphite.